# FASCICULE DE BREVET EUROPEEN

(11) **EP 3 689 114 B1**
(45) Date de publication et mention de la délivrance du brevet: **08.05.2024**
(21) Numéro de dépôt: 18753194.2
(22) Date de dépôt: 16.08.2018
(51) Int. Cl.: H05K 5/00

(54) **BOITIER COMPORTANT UNE PREMIERE PORTION DE BOITIER, UNE DEUXIEME PORTION DE BOITIER ET UNE TROISIEME PORTION DE BOITIER**
GEHÄUSE MIT EINEM ERSTEN GEHÄUSETEIL, EINEM ZWEITEN GEHÄUSETEIL UND EINEM DRITTEN GEHÄUSETEIL
HOUSING COMPRISING A FIRST HOUSING PORTION, A SECOND HOUSING PORTION AND A THIRD HOUSING PORTION

(30) Priorité: 28.09.2017 FR 1759035
(43) Date de publication de la demande: 05.08.2020
(73) Titulaire: Sagemcom Broadband SAS, 92270 Bois-Colombes (FR)
(72) Inventeur: MAURECH, Cécile, 92500 Rueil Malmaison (FR); LE HENANFF, Yann, 92500 Rueil Malmaison (FR)
(74) Mandataire: Cabinet Boettcher
(86) Numéro de dépôt international: PCT/EP2018/072196
(87) Numéro de publication internationale: WO 2019/063192

(56) Documents cités:
- FR-A3- 2 737 837
- US-A- 5 551 589
- US-A1- 2014 290 142
- US-A1- 2017 064 842

## Description

L'invention concerne le domaine des boîtiers comportant une première portion de boîtier, une deuxième portion de boîtier et une troisième portion de boîtier.

### ARRIERE PLAN DE L'INVENTION

De très nombreux boîtiers comportent une pluralité de portions de boîtier, fabriquées en plastique, qui sont assemblées au moment du montage des boîtiers.

Ces boîtiers sont par exemple (mais pas nécessairement) des boîtiers d'équipements électriques : boîtiers de décodeurs, de passerelles résidentielles, de compteurs électriques, etc.

Les portions de boîtier doivent être maintenues mécaniquement les unes aux autres, et leurs positions relatives doivent être ajustées.

Dans le cas des boîtiers comportant deux portions de boîtier, le maintien mécanique est classiquement assuré par encliquetage, et la position relative des portions de boîtier est ajustée par exemple en réglant l'épaisseur d'une bordure, en ajoutant un ou des godrons, en mettant en œuvre une fonction de centrage et de positionnement d'une portion de boîtier par rapport à l'autre, etc.

L'ajustement des positions relatives doit être précis. En effet, si l'encliquetage est trop serré, les portions de boîtier ne peuvent pas être assemblées. Si l'encliquetage n'est pas assez serré, il existe un jeu trop important entre les deux portions de boîtier. De même, si l'épaisseur des bordures ou des godrons n'est pas bonne, un désaffleurement peut être observé.

Bien sûr, la problématique qui vient d'être évoquée est encore plus complexe à résoudre dans le cas où le boîtier comporte trois portions de boîtier.

Dans ce cas, les solutions classiques consistent soit à accepter un décalage entre les portions de boîtier, quitte éventuellement à utiliser un artifice de design pour rendre acceptable ledit décalage, soit à concevoir des portions de boîtier appairées, soit à utiliser des cotes de fabrication avec des tolérances très fines. Ces deux dernières solutions sont bien sûr très coûteuses.

Le document FR 2 737 837 A3 dévoile un boîtier comprenant trois portions de boîtier et des moyens d'encliquetage pour assembler ces portions. Le document US 5 551 589 A divulgue un boîtier comprenant deux portions de boîtier.

### OBJET DE L'INVENTION

L'invention a pour objet de réaliser un assemblage précis d'un boîtier comprenant une première portion de boîtier, une deuxième portion de boîtier et une troisième portion de boîtier, sans augmenter le coût de fabrication dudit boîtier et sans utiliser d'artifice de design.

### RESUME DE L'INVENTION

En vue de la réalisation de ce but, on propose un boîtier comportant une première portion de boîtier, une deuxième portion de boîtier et une troisième portion de boîtier, la première portion de boîtier et la deuxième portion de boîtier comprenant des moyens d'encliquetage complémentaires formés dans une paroi de la première portion de boîtier et dans une première paroi de la deuxième portion de boîtier et agencés pour que, lorsque la première portion de boîtier et la deuxième portion de boîtier sont assemblées et en l'absence de la troisième portion de boîtier, un jeu axial existe selon un axe parallèle à la paroi de la première portion de boîtier et à la première paroi de la deuxième portion de boîtier qui sont parallèles entre elles, la deuxième portion de boîtier et la troisième portion de boîtier comprenant des moyens d'ajustement complémentaires agencés pour que, lorsque la troisième portion de boîtier est assemblée avec la première portion de boîtier et avec la deuxième portion de boîtier, le jeu axial soit réduit et la position de la deuxième portion de boîtier et de la troisième portion de boîtier soit ajustée selon l'axe.

Les moyens d'ajustement complémentaires permettent donc d'ajuster la position de la deuxième portion de boîtier et de la troisième portion de boîtier, et de réduire le jeu axial entre la première portion de boîtier et la deuxième portion de boîtier. Ainsi, grâce aux moyens d'encliquetage complémentaires et aux moyens d'ajustement complémentaires, la première portion de boîtier, la deuxième portion de boîtier et la troisième portion de boîtier sont fixées entre elles et leur position relative est ajustée de manière très précise.

Cet ajustement très précis ne nécessite pas de fabriquer la première portion de boîtier, la deuxième portion de boîtier et la troisième portion de boîtier avec des cotes de fabrication ayant des tolérances très fines. Le coût de fabrication n'est donc pas augmenté.

La précision du montage du boîtier rend inutile tout artifice de design.

On propose aussi un procédé de montage d'un boîtier semblable à celui qui vient d'être décrit, comprenant les étapes de :
- assembler la première portion de boîtier, la deuxième portion de boîtier et la troisième portion de boîtier ;
- fixer la troisième portion de boîtier à la première portion de boîtier.

D'autres caractéristiques et avantages de l'invention ressortiront à la lecture de la description qui suit de modes de réalisation particuliers non limitatifs de l'invention.

### BREVE DESCRIPTION DES DESSINS

Il sera fait référence aux dessins annexés, parmi lesquels :
- la figure 1 représente une première portion de boîtier et une deuxième portion de boîtier d'un boîtier selon un premier mode de réalisation de l'invention ;
- la figure 2 représente la deuxième portion de boîtier et une troisième portion de boîtier ;
- la figure 3 représente la troisième portion de boîtier ;
- la figure 4 est une vue de section des moyens d'encliquetage complémentaires et des moyens d'ajustement complémentaires du boîtier, dans un plan perpendiculaire à la première paroi et à la deuxième paroi ;
- la figure 5 est une vue analogue à celle de la figure 4, pour un boîtier selon un deuxième mode de réalisation de l'invention ;
- la figure 6 représente des moyens d'encliquetage complémentaires et des moyens d'ajustement complémentaires d'un boîtier selon un troisième mode de réalisation de l'invention.

### DESCRIPTION DETAILLEE DE L'INVENTION

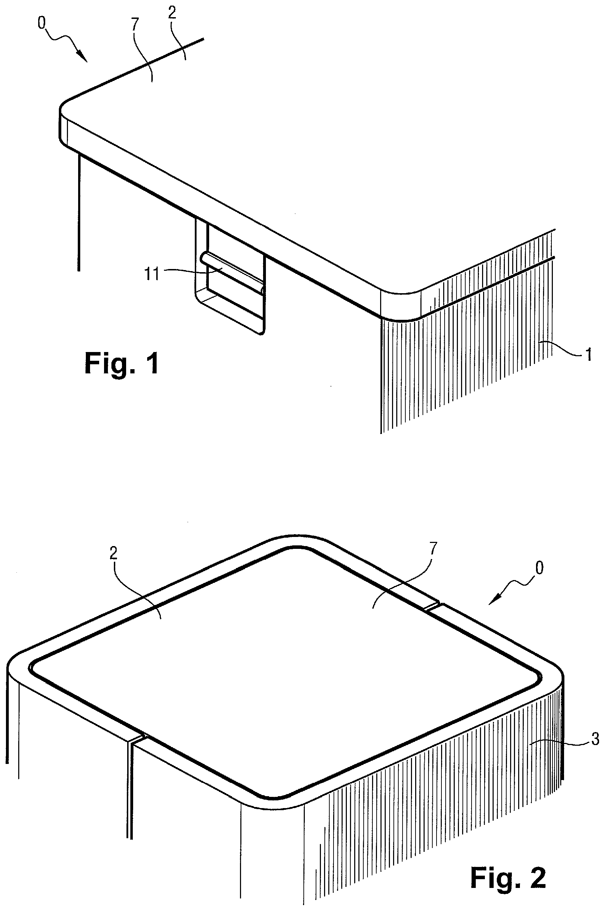

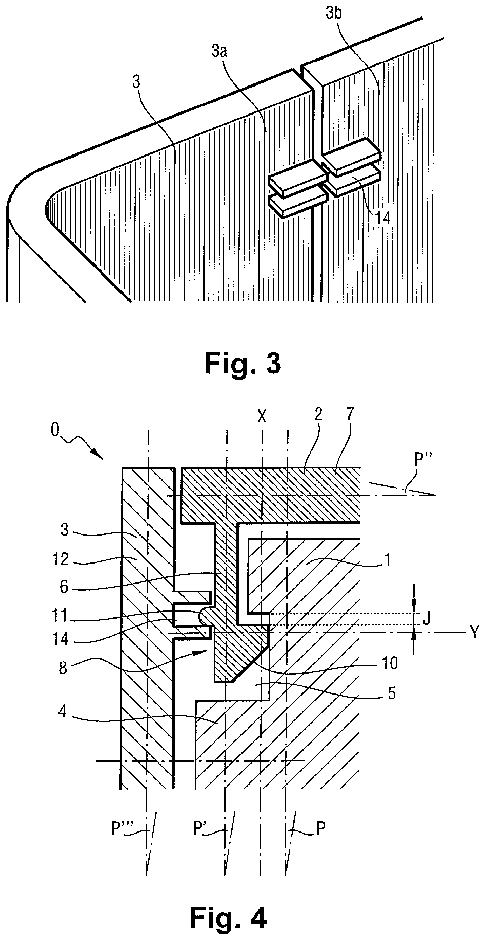

En référence aux figures 1 à 4, un boîtier 0 selon un premier mode de réalisation de l'invention comporte une première portion de boîtier 1, une deuxième portion de boîtier 2 et une troisième portion de boîtier 3. La première portion de boîtier 1, la deuxième portion de boîtier 2 et la troisième portion de boîtier 3 sont fabriquées en plastique.

La première portion de boîtier 1 et la deuxième portion de boîtier 2 définissent un volume interne du boîtier 0.

La première portion de boîtier 1 comporte une paroi 4 qui s'étend dans un plan P.

Un premier évidement 5 est pratiqué dans la paroi 4 de la première portion de boîtier 1.

La deuxième portion de boîtier 2 comporte une première paroi 6 et une deuxième paroi 7. La première paroi 6 s'étend dans un plan P' qui est parallèle au plan P lorsque la première portion de boîtier 1 et la deuxième portion de boîtier 2 sont assemblées. La deuxième paroi 7 s'étend dans un plan P" perpendiculaire au plan P'. La deuxième paroi 7 de la deuxième portion de boîtier 2 forme un couvercle du boîtier 0.

Une patte d'accrochage flexible 8 est réalisée dans une épaisseur de la première paroi 6 de la deuxième portion de boîtier 2.

La patte d'accrochage flexible 8 présente une première face et une deuxième face opposée à la première face.

La première face de la patte d'accrochage flexible 8 s'étend partiellement en regard du premier évidement 5 lorsque la première portion de boîtier 1 et la deuxième portion de boîtier 2 sont assemblées. La première face présente une pente 10 orientée en direction du premier évidement 5 lorsque la première portion de boîtier 1 et la deuxième portion de boîtier 2 sont assemblées. La pente 10, formant un crochet, s'étend depuis une extrémité libre de la patte d'accrochage flexible 8.

Un ergot 11 est pratiqué sur la première paroi 6 de la deuxième portion de boîtier 2. L'ergot 11 est situé sur la deuxième face de la patte d'accrochage flexible 8. L'ergot 11 s'étend longitudinalement sur toute une largeur de la patte d'accrochage flexible 8.

La troisième portion de boîtier 3 comporte une paroi 12 qui s'étend dans un plan P‴ qui est parallèle au plan P et au plan P' lorsque la première portion de boîtier 1, la deuxième portion de boîtier 2 et la troisième portion de boîtier 3 sont assemblées.

La troisième portion de boîtier 3 comporte une première pièce 3a et une deuxième pièce 3b semblables.

Un deuxième évidement 14 est pratiqué sur la paroi 12 de la troisième portion de boîtier 3. Le deuxième évidement 14 s'étend à moitié sur la première pièce 3a et à moitié sur la deuxième pièce 3b. Le deuxième évidement 14 s'étend longitudinalement sur une longueur proche de celle de l'ergot 11.

On définit maintenant plus en détail l'assemblage de la première portion de boîtier 1, de la deuxième portion de boîtier 2 et de la troisième portion de boîtier 3.

Le premier évidement 5 de la paroi 4 de la première portion de boîtier 1 et la patte d'accrochage flexible 8 de la première paroi 6 de la deuxième portion de boîtier 2 forment des moyens d'encliquetage complémentaires. On utilise le terme « encliquetage » pour désigner un engagement élastique d'une pièce dans une autre.

Lorsque la première portion de boîtier 1 et la deuxième portion de boîtier 2 sont assemblées, les moyens d'encliquetage complémentaires permettent de fixer la deuxième portion de boîtier 2 à la première portion de boîtier 1. La paroi 4 de la première portion de boîtier 1 et la première paroi 6 de la deuxième portion de boîtier 2 sont parallèles entre elles. Un jeu axial J existe entre la première portion de boîtier 1 et la deuxième portion de boîtier 2 selon un axe X parallèle à la paroi 4 de la première portion de boîtier 1 et à la première paroi 6 de la deuxième portion de boîtier 2, c'est-à-dire parallèle au plan P et au plan P'. La deuxième portion de boîtier 2 est donc maintenue tout en étant montée flottante sur la première portion de boîtier 1. Le jeu axial J peut être relativement important, par exemple supérieur à 0,5mm.

Puis, la troisième portion de boîtier 3 est assemblée avec la première portion de boîtier 1 et avec la deuxième portion de boîtier 2.

La première pièce 3a et la deuxième pièce 3b de la troisième portion de boîtier 3 sont ajustées et alignées l'une par rapport à l'autre.

L'ergot 11 de la deuxième portion de boîtier 2 et le deuxième évidement 14 de la troisième portion de boîtier 3 forment des moyens d'ajustement complémentaires.

Les moyens d'ajustement complémentaires sont agencés pour que, lorsque la troisième portion de boîtier 3 est assemblée avec la première portion de boîtier 1 et avec la deuxième portion de boîtier 2, l'ergot 11 pénètre dans le deuxième évidement 14. Le jeu axial de l'ergot 11 positionné dans le deuxième évidement 14 est très faible. La troisième portion de boîtier 3 finalise ainsi l'ajustement fonctionnel de la deuxième portion de boîtier 2 selon l'axe X : la position de la deuxième portion de boîtier 2 et la position de la troisième portion de boîtier 3 sont ajustées selon l'axe X.

La troisième portion de boîtier 3 est alors ajustée par rapport à la première portion de boîtier 1, puis est fixée à la première portion de boîtier 1 par vissage, encliquetage, collage ou bouterollage.

La première portion de boîtier 1, la deuxième portion de boîtier 2 et la troisième portion de boîtier 3 sont ainsi fixées entre elles et leurs positions relatives sont parfaitement ajustées selon l'axe X.

L'ajustement selon l'axe X est ainsi réalisé au niveau d'une zone d'ajustement très proche de la deuxième paroi 7 de la deuxième portion de boîtier 2 et de la paroi 12 de la troisième portion de boîtier 3, qui sont les parois du boîtier 0 visibles depuis l'extérieur. Aucun décalage de paroi n'est donc visible depuis l'extérieur du boîtier 0.

On sait qu'au cours de la fabrication de pièces plastiques, suite à l'injection, les pièces plastiques ont tendance à se rétracter. Ici, comme la zone d'ajustement est très proche de de la deuxième paroi 7 de la deuxième portion de boîtier 2 et de la paroi 12 de la troisième portion de boîtier 3, les longueurs concernées sont très réduites et l'ajustement est bien maîtrisé et donc très précis.

On peut ainsi obtenir un ajustement inférieur à 0,2mm, alors que des tolérances obtenues dans un boîtier classique, comprenant des pièces ayant des cotes de fabrication avec des tolérances similaires, seraient plutôt supérieures à 0,8mm.

On note que le système d'indexation de la troisième portion de boîtier 3 sur la première portion de boîtier 1 peut être réalisé grâce à des moyens d'indexation situés sur la première portion de boîtier 1 et sur la troisième portion de boîtier 3, ou bien via un ou des éléments rapportés, comprenant par exemple une goupille, un fourreau, etc. Le ou les éléments rapportés peuvent être sertis, bouterollés, collés, etc.

On note par ailleurs que la troisième portion de boîtier 3 contraint le crochet de la patte d'accrochage flexible 8 dans le premier évidement 5, ce qui ajuste aussi les positions relatives de la première portion de boîtier 1, de la deuxième portion de boîtier 2 et de la troisième portion de boîtier 3 selon un axe Y perpendiculaire à l'axe X et aux plans P, P' et P‴.

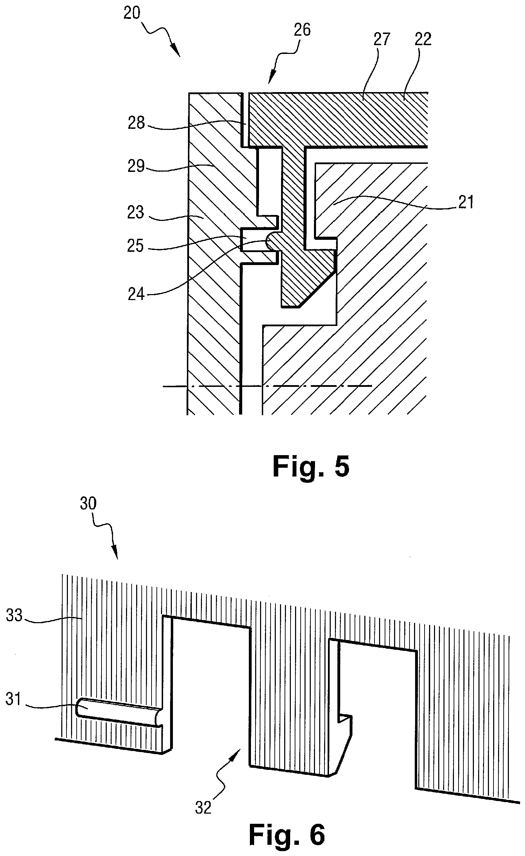

En référence à la figure 5, un boîtier 20 selon un deuxième mode de réalisation de l'invention comporte à nouveau une première portion de boîtier 21, une deuxième portion de boîtier 22 et une troisième portion de boîtier 23.

Les moyens d'ajustement complémentaires comportent à nouveau un ergot 24 et un évidement 25 semblables à l'ergot 11 et au deuxième évidement 14 qui viennent d'être décrits, mais aussi une extrémité 26 de la deuxième paroi 27 de la deuxième portion de boîtier 22 et un épaulement 28 pratiqué dans la paroi 29 de la troisième portion de boîtier 23.

L'ajustement est ainsi réalisé juste sous le couvercle du boîtier 20, ce qui améliore encore la précision de l'ajustement.

En référence à la figure 6, les moyens d'ajustement complémentaires d'un boîtier 30 selon un troisième mode de réalisation de l'invention sont semblables à ceux du premier mode de réalisation, si ce n'est que l'ergot 31 n'est pas situé sur la deuxième face de la patte d'accrochage flexible 32, mais sur une portion voisine de la première paroi de la deuxième portion de boîtier 33. Bien sûr, le deuxième évidement de la troisième portion de boîtier est décalé en conséquence.

Bien entendu, l'invention n'est pas limitée aux modes de réalisation décrits mais englobe toute variante entrant dans le champ de l'invention telle que définie par les revendications.

La première portion de boîtier, la deuxième portion de boîtier et la troisième portion de boîtier peuvent être fabriquées dans des matières différentes les unes des autres.

L'encliquetage entre la première portion de boîtier et la deuxième portion de boîtier peut être démontable ou non, et peut utiliser des moyens d'encliquetage présentant une forme différente de celle décrite ici.

L'ajustement entre les portions de boîtiers peut être fait selon un axe différent, voire même selon plusieurs axes de manière combinée.

Le boîtier peut parfaitement comporter un nombre de portions de boîtier supérieur à 3.

Les moyens d'ajustement complémentaires entre la deuxième portion de boîtier et la troisième portion de boîtier peuvent présenter une forme différente, et peuvent par exemple comprendre un pion, une nervure, un dispositif de centrage, etc.

## Revendications

1. Boîtier comportant une première portion de boîtier (1 ; 21), une deuxième portion de boîtier (2 ; 22) et une troisième portion de boîtier (3 ; 23), la première portion de boîtier et la deuxième portion de boîtier comprenant des moyens d'encliquetage complémentaires (5, 8) formés dans une paroi (4) de la première portion de boîtier et dans une première paroi (6) de la deuxième portion de boîtier, le boîtier étant **caractérisé en ce que** les moyens d'encliquetage complémentaires sont agencés pour que, lorsque la première portion de boîtier et la deuxième portion de boîtier sont assemblées et en l'absence de la troisième portion de boîtier, un jeu axial (J) existe selon un axe (X) parallèle à la paroi de la première portion de boîtier et à la première paroi de la deuxième portion de boîtier qui sont parallèles entre elles, la deuxième portion de boîtier et la troisième portion de boîtier comprenant des moyens d'ajustement complémentaires (11, 14 ; 24, 25, 26, 28 ; 31) agencés pour que, lorsque la troisième portion de boîtier est assemblée avec la première portion de boîtier et avec la deuxième portion de boîtier, le jeu axial soit réduit et la position de la deuxième portion de boîtier et de la troisième portion de boîtier soit ajustée selon l'axe (X).

2. Boîtier selon la revendication 1, dans lequel, lorsque la troisième portion de boîtier est assemblée avec la première portion de boîtier et avec la deuxième portion de boîtier, la troisième portion de boîtier est fixée à la première portion de boîtier.

3. Boîtier selon la revendication 2, dans lequel la troisième portion de boîtier est fixée à la première portion de boîtier par vissage, encliquetage, collage ou bouterollage.

4. Boîtier selon la revendication 1, dans lequel les moyens d'encliquetage complémentaires comprennent un premier évidement (5) pratiqué dans la paroi de la première portion de boîtier et une patte d'accrochage flexible (8) réalisée dans une épaisseur de la première paroi (6) de la deuxième portion de boîtier (2).

5. Boîtier selon la revendication 4, dans lequel la patte d'accrochage flexible (8) comporte une première face présentant une pente (10) orientée en direction du premier évidement (5) lorsque la première portion de boîtier et la deuxième portion de boîtier sont assemblées.

6. Boîtier selon la revendication 1, dans lequel les moyens d'ajustement complémentaires sont pratiqués sur la première paroi de la deuxième portion de boîtier et sur une paroi de la troisième portion de boîtier.

7. Boîtier selon la revendication 6, dans lequel les moyens d'ajustement complémentaires comprennent un ergot (11 ; 24 ; 31) pratiqué sur la première paroi de la deuxième portion de boîtier et un deuxième évidement (14 ; 25) pratiqué sur la paroi de la troisième portion de boîtier.

8. Boîtier selon les revendications 4 et 7, dans lequel l'ergot est situé sur la patte d'accrochage flexible.

9. Boîtier selon les revendications 5 et 8, dans lequel l'ergot est situé sur une deuxième face de la patte d'accrochage flexible opposée à la première face.

10. Boîtier selon la revendication 6, dans lequel les moyens d'ajustement complémentaires comportent une extrémité (26) d'une deuxième paroi de la deuxième portion de boîtier, qui s'étend orthogonalement à la première paroi de la deuxième portion de boîtier, et un épaulement (28) pratiqué dans la paroi de la troisième portion de boîtier.

11. Procédé de montage d'un boîtier selon l'une des revendications précédentes, comprenant les étapes de :
- assembler la première portion de boîtier, la deuxième portion de boîtier et la troisième portion de boîtier ;
- fixer la troisième portion de boîtier à la première portion de boîtier.

## Patentansprüche

1. Gehäuse, umfassend einen ersten Gehäuseteil (1; 21), einen zweiten Gehäuseteil (2; 22) und einen dritten Gehäuseteil (3; 23), wobei der erste Gehäuseteil und der zweite Gehäuseteil komplementäre Rastmittel (5, 8) umfassen, die in einer Wand (4) des ersten Gehäuseteils und in einer ersten Wand (6) des zweiten Gehäuseteils ausgebildet sind, wobei das Gehäuse **dadurch gekennzeichnet ist, dass** die komplementären Rastmittel so ausgebildet sind, dass, wenn der erste Gehäuseteil und der zweite Gehäuseteil zusammengefügt sind, und bei Nichtvorhandensein des dritten Gehäuseteils, ein axiales Spiel (J) entlang einer Achse (X) parallel zur Wand des ersten Gehäuseteils und zur ersten Wand des zweiten Gehäuseteils, die parallel zueinander sind, vorhanden ist, wobei der zweite Gehäuseteil und der dritte Gehäuseteil komplementäre Einstellmittel (11, 14; 24, 25, 26, 28; 31) umfassen, die so ausgebildet sind, dass, wenn der dritte Gehäuseteil mit dem ersten Gehäuseteil und dem zweiten Gehäuseteil zusammengefügt ist, das axiale Spiel reduziert ist und die Position des zweiten Gehäuseteils und des dritten Gehäuseteils entlang der Achse (X) eingestellt ist.

2. Gehäuse nach Anspruch 1, bei dem, wenn der dritte Gehäuseteil mit dem ersten Gehäuseteil und mit dem zweiten Gehäuseteil zusammengefügt ist, der dritte Gehäuseteil an dem ersten Gehäuseteil befestigt ist.

3. Gehäuse nach Anspruch 2, bei dem der dritte Gehäuseteil an dem ersten Gehäuseteil durch Schrauben, Einrasten, Kleben oder Döppern befestigt ist.

4. Gehäuse nach Anspruch 1, bei dem die komplementären Rastmittel eine erste Aussparung (5) umfassen, die in der Wand des ersten Gehäuseteils ausgebildet ist, und eine flexible Befestigungslasche (8), die in einer Dicke der ersten Wand (6) des zweiten Gehäuseteils (2) ausgebildet ist.

5. Gehäuse nach Anspruch 4, bei dem die flexible Befestigungslasche (8) eine erste Fläche umfasst, die eine Schräge (10) aufweist, die in Richtung der ersten Aussparung (5) gerichtet ist, wenn der erste Gehäuseteil und der zweite Gehäuseteil zusammengefügt sind.

6. Gehäuse nach Anspruch 1, bei dem die komplementären Einstellmittel an der ersten Wand des zweiten Gehäuseteils und an einer Wand des dritten Gehäuseteils ausgebildet sind.

7. Gehäuse nach Anspruch 6, bei dem die komplementären Einstellmittel eine Nase (11; 24; 31) umfassen, die an der ersten Wand des zweiten Gehäuseteils ausgebildet ist, und eine zweite Aussparung (14; 25), die an der Wand des dritten Gehäuseteils ausgebildet ist.

8. Gehäuse nach den Ansprüchen 4 und 7, bei dem sich die Nase auf der flexiblen Befestigungslasche befindet.

9. Gehäuse nach den Ansprüchen 5 und 8, bei dem sich die Nase auf einer zweiten Fläche der flexiblen Befestigungslasche befindet, die der ersten Fläche entgegengesetzt ist.

10. Gehäuse nach Anspruch 6, bei dem die komplementären Einstellmittel ein Ende (26) einer zweiten Wand des zweiten Gehäuseteils umfassen, das sich orthogonal zur ersten Wand des zweiten Gehäuseteils erstreckt, und eine Schulter (28), die in der Wand des dritten Gehäuseteils ausgebildet ist.

11. Verfahren zur Montage eines Gehäuses nach einem der vorhergehenden Ansprüche, umfassend die Schritte:
- Zusammenfügen des ersten Gehäuseteils, des zweiten Gehäuseteils und des dritten Gehäuseteils;
- Befestigen des dritten Gehäuseteils an dem ersten Gehäuseteil.

## Claims

1. A box comprising a first box portion (1; 21), a second box portion (2; 22), and a third box portion (3; 23), the first box portion and the second box portion comprising complementary snap fastener means (5, 8) formed in a wall (4) of the first box portion and in a first wall (6) of the second box portion, the box being **characterized in that** the complementary snap fastener means are arranged so that, when the first box portion and the second box portion are assembled together, and in the absence of the third box portion, axial clearance (J) exists along an axis (X) parallel to the wall of the first box portion and to the first wall of the second box portion, which walls are parallel to each other, the second box portion and the third box portion comprising complementary adjustment means (11, 14; 24, 25, 26, 28; 31) arranged so that, when the third box portion is assembled with the first box portion and the second box portion, the axial clearance is reduced and the position of the second box portion and of the third box portion is adjusted along the axis (X).

2. The box according to claim 1, wherein, when the third box portion is assembled with the first box portion and with the second box portion, the third box portion is secured to the first box portion.

3. The box according to claim 2, wherein the third box portion is secured to the first box portion by a screw fastening, by snap fastening, by adhesive, or by thermoplastic staking.

4. The box according to claim 1, wherein the complementary snap fastener means comprise a first recess (5) formed in the wall of the first box portion and a flexible catch tab (8) formed in the thickness of the first wall (6) of the second box portion (2).

5. The box according to claim 4, wherein the flexible catch tab (8) has a first face presenting a slope (10) facing towards the first recess (5) when the first box portion and the second box portion are assembled together.

6. The box according to claim 1, wherein the complementary adjustment means are formed on the first wall of the second box portion and on a wall of the third box portion.

7. The box according to claim 6, wherein the complementary adjustment means comprise a lug (11; 24; 31) formed on the first wall of the second box portion, and a second recess (14; 25) formed in the wall of the third box portion.

8. The box according to claims 4 and 7, wherein the lug is situated on the flexible catch tab.

9. The box according to claims 5 and 8, wherein the lug is situated on a second face of the flexible catch tab that is opposite from the first face.

10. The box according to claim 6, wherein the complementary adjustment means comprise an end (26) of a second wall of the second box portion that extends orthogonally to the first wall of the second box portion, and a shoulder (28) formed in the wall of the third box portion.

11. A method of making a box according to any one of preceding claims, the method comprising the steps of:
· assembling together the first box portion, the second box portion, and the third box portion;
· securing the third box portion to the first box portion.
